# EUROPEAN PATENT SPECIFICATION

(11) **EP 0 651 385 B1**
(45) Date of publication and mention of the grant of the patent: **29.09.1999**
(21) Application number: 94710009.5
(22) Date of filing: 26.10.1994
(51) Int. Cl.: G11B 15/28, C23C 16/26

(54) **Method for producing diamond-like carbon film and tape driving apparatus**
Herstellungsverfahren für diamantähnlichen Kohlenstoffilm und Bandantriebsgerät
Méthode de production d'un film de carbone semblable à du diamant et appareil d'entrainement de bande

(30) Priority: 28.10.1993 JP 29475293; 24.05.1994 JP 10966194
(43) Date of publication of application: 03.05.1995
(73) Proprietor: MATSUSHITA ELECTRIC INDUSTRIAL CO., LTD., Kadoma-shi, Osaka-fu, 571 (JP)
(72) Inventor: Nakaue, Hirokazu, Higashiosaka-shi, Osaka-fu (JP); Kurokawa, Hideo, Katano-shi, Osaka-fu (JP); Ueda, Sadayasu, deseased (JP)
(74) Representative: Eisenführ, Speiser & Partner

(56) References cited:
- EP-A- 0 474 099
- EP-A- 0 474 369
- US-A- 4 935 303
- THIN SOLID FILMS, vol.212, no.1&2, 15 May 1992, LAUSANNE CH pages 240 - 244, XP360221 NAKAUE ET AL. 'applications of diamond-like carbon films to electronic components.'
- C.I.P. 93 PROCEEDINGS, 6 June 1993, ANTIBES-JUAN LES PINS pages 213 - 215, XP399246 DESHAYES ET AL. 'Modification of stainless steal surface by plasma treatment prior to PACDV deposition of amorfhous hydrogenated carbon films'

## Description

### BACKGROUND OF THE INVENTION

### Field of the Invention

The present invention relates to a method for producing a diamond-like carbon film and a magnetic tape driving apparatus which is used in a video tape recorder, a cassette deck, and the like.

### Description of the Related Art

Hitherto, in a magnetic recording-reproducing apparatus such as a video tape recorder, a cassette tape recorder, and the like, a magnetic tape is pressed to a capstan axle by a pinch roller and driven by the constant rotation of the capstan axle.

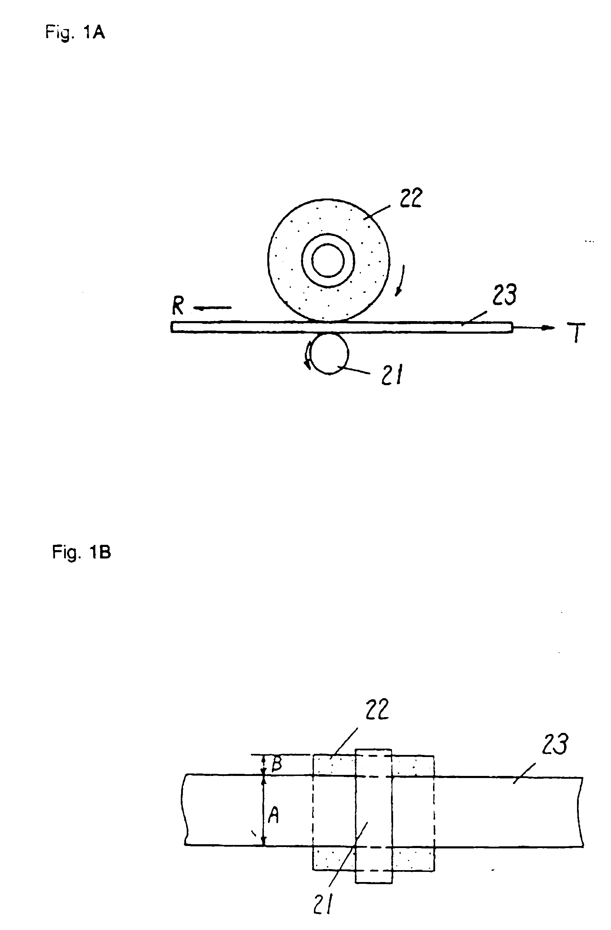

Now, a tape driving apparatus will be explained by making reference to Figs. 1A and 1B. The apparatus of Fig. 1 comprises a capstan axle 21 and a pinch roller 22 which is movable in a direction of the capstan axis and rotates with pressing a magnetic tape 23 to the capstan axle 21.

Since the pinch roller 22 presses the magnetic tape 23 to the capstan axle 21, the magnetic tape 23 is conveyed in a rotation direction of the capstan axle 21 according to a rotation speed of the capstan axle 21. To prevent tape slip, a pressing force of the pinch roller 22 to the capstan axle 21 is usually set at 1 kg or larger. By the formation of minute unevenness on a surface of the capstan axle 21, a frictional force between the surface of the capstan axle 21 and the magnetic tape 23 is increased and in turn a tape driving force is increased, whereby the tape slip is suppressed. In addition, unpublished Japanese Patent Application No. 3-209161 discloses a tape driving apparatus comprising a capstan axle 21 on a surface of which a diamond-like carbon film (hereinafter referred to as "DLC film") is formed to increase the tape driving force by utilizing frictional sliding characteristics and wear resistance of the of the DLC film.

In the article "Applications of Diamond-like Films to Electronic Components" published by Nakaue et al. at pages 240 to 244 of "Thin Solid Films" vol. 212 (1992) May 15, Nos. 1/2 (Lausanne, Switzerland) representing the closest prior art from which the invention proceeds it is described that DLC films show remarkable characteristics such as high mechanical hardness, low friction and chemical stability so that such films are very suitable as protective layers. In this article, DLC films are examined as protective layers for metal evaporated tapes, cylinders and capstans which are used in video tape recorders.

Since the DLC film is amorphous but has the properties similar to diamond, it is expected to find wide variety of applications including a tribology field. As a synthesis method of the DLC film, Japanese Patent Application No. 3-209161 discloses an ionization vapor deposition method, which is also known as an ion beam method. In this method, a raw material gas is decomposed to produce a plasma by colliding thermoions from a heating filament to the raw material gas in a relatively high vacuum atmosphere, imparting a high accelerating energy to ions in the plasma by the application of a high bias to the substrate, and forming the DLC film on the substrate. By this method, the DLC film which is excellent in film properties and adhesion to the substrate can be formed. In addition, as the synthesis methods of the DLC film, there have been reported a plasma CVD method, an ion beam sputtering method, an ion plating method, and so on.

The plasma CVD method uses, as a raw material, a gas material such as a hydrocarbon or carbon monoxide, generates a plasma of the raw material using a high frequency wave, a microwave or a direct current and forms the DLC film by utilizing ions or radicals in the plasma (cf., for example, JP-B-1,479,432).

The ion beam sputtering method comprises irradiating a solid target as a carbon source (e.g. graphite) by an ion beam of, for example, argon or xenon to sputter carbon atoms or their clusters from the target by the energy of the ions and depositing the carbon atoms or their clusters on a substrate (cf., for example, JP-A-122197/1986).

The ion plating method uses a hydrocarbon gas or a solid target as a carbon source. When the hydrocarbon gas is used, the method comprises generating a plasma of the raw material as in the plasma CVD method, accelerating the ions in the plasma by the application of a negative potential to a substrate and depositing them on the substrate. When the solid target is used, the method comprises melting the target by, for example, electron beam irradiation, ionizing a part of evaporated particles by, for example, a high frequency wave and depositing it on a substrate.

However, any of the above methods except the ion beam method cannot provide a DLC film having a film property or adhesion which is sufficient for use in the production of a capstan axle. This is because the decomposed components of the raw material gas or a target or vaporized particles do not have sufficiently high kinetic energy for the synthesis of a diamond bond component. Accordingly, a good quality DLC film cannot be synthesized. In addition, the insufficiency of the kinetic energy has an adverse effect on the adhesion of the DLC film to the substrate so that the film is easily peeled off. Since a high shear force is applied on the capstan axle by the pressing of the pinch roller, the DLC is required to have the good film quality and the adhesion. For such reasons, the ion beam method is employed.

When the DLC film which is formed by the ion beam method and excellent in wear resistance or the sliding characteristics is used, the driving force of the tape driving apparatus is increased.

In the magnetic recording-reproducing apparatus such as the video tape recorder, the cassette deck, and the like, a mechanism for stably driving the magnetic tape is one of the important techniques. The stable driving of the tape is realized by pressing the tape to the capstan axle by the pinch roller with a suitable pressing force. When the pressing force is too small, slip occurs between the capstan axle and the magnetic tape so that the stable driving of the magnetic tape is difficult.

Recently, parts constituting a mechanical part or a chassis are made small and light weight close to their limits for reducing a size and a weight of, in particular, a video movie. Therefore, the mechanical part such as a pinch arm and the like is easily strained or warped when it is pressed by the pinch roller. Further, since a size of the capstan axle or a bearing for the capstan axle is reduced, an acceptable load is decreased. Then, when the pressing force of the pinch roller is large, a life of the bearing is shortened.

Therefore, it is desired to decrease the pressing force of the pinch roller. That is, it is important to reduce the pressing force of the pinch roller as much as possible while preventing the slip of the tape.

The driving force of the capstan for conveying the tape is generated by the frictional forces between the capstan axle and the tape and between the pinch roller and the tape, but with the conventional capstan, it is believed that the driving force is generated by the frictional force between the pinch roller and the tape. A reason for this belief may be as follows:

In the conventional tape driving apparatus, since a width of the pinch roller is wider than that of the magnetic tape, a part of the pinch roller contacts directly the capstan. Then, a part of a rotational force of the capstan axle is conveyed directly to the pinch roller and, in turn, from the pinch roller to the tape. Since the pinch roller is made of an elastic material such as a rubber while the surface of the capstan axle is smoothed in an order of several micrometers or less, a coefficient of friction between the tape and the pinch roller or between the capstan axle and the pinch roller is larger than that between the tape and the capstan axle.

To increase the frictional force between the capstan axle and the tape, it is contemplated to provide minute unevenness onto the surface of the capstan axle. That is, with the unevenness on the surface of the capstan axle, a coefficient of friction between the capstan axle and the tape is increased so as to realize the stable tape traveling. However, in this case, the unevenness disappears gradually and the surface of the capstan axle is smoothed. Then, the tape driving force is decreased.

### SUMMARY OF THE INVENTION

An object of the present invention is to provide a tape driving apparatus comprising a capstan axle which has a specific diamond-like film on its peripheral surface.

In order to achieve the above object, according to the present invention, there is provided a tape driving apparatus comprising a capstan axle and a pinch roller which presses a magnetic tape to the capstan axle wherein said capstan axle comprises, as an outermost layer, a diamond-like carbon film having a Knoop hardness of at least 5000 kg/mm², characterized in that said diamond-like carbon film of said capstan axle has a density of not larger than 3 g/cm³, and a ratio of the width of a part of said capstan axle contacting said pinch roller to the width of a part of said capstan axle contacting directly said magnetic tape is not larger than 0.8.

Further advantageous embodiments are defined in the dependent claims.

### BRIEF DESCRIPTION OF THE DRAWINGS

Figs. 1A and 1B are side view and a plan view of a tape driving apparatus, respectively.
Fig. 2A is a perspective view of a first example of a capstan axle of the present invention.
Fig. 2B is an enlarged view of a partial cross section of the capstan axle of Fig. 2A,
Fig. 3 shows an apparatus for forming a DLC film or a silicon-containing carbon film,
Fig. 4 is a graph showing a relationship between the Knoop hardness and the substrate bias in Example 1,
Fig. 5 shows the Raman spectra of the films (a) and (b) formed in Example 1,
Fig. 6 shows the electron beam diffraction patterns of the films (a) and (b) formed in Example 1,
Fig. 7 are the transmission electron micrographs of the films (a) and (b) formed in Example 1,
Fig. 8 is a graph showing aging characteristics of the driving force of the capstan axles produced in Example 1,
Fig. 9 is a graph showing aging characteristics of the driving force of the capstan axles produced in Example 2,
Fig. 10 is a graph showing a relationship between a driving force and a ratio of the width B to the width A in Fig. 1B,
Fig. 11 is a graph showing an influence of the thickness of the DLC film on the driving force,
Fig. 12 is an enlarged view of a cross section of a second example of the capstan axle of the present invention,
Fig. 13 is a graph showing a relationship between the Knoop hardness of the DLC film and the substrate bias,
Fig. 14 is a graph showing a relationship between the driving force and the aging time in Example 2,
Fig. 15 is a graph showing a relationship between a driving force and a ratio of the width B to the width A in Fig. 1B in Example 2,
Fig. 16 is a graph showing a relationship between the tape driving force and the aging time in Example 2,
Fig. 17 is a graph showing relationships between the Knoop hardness and the substrate bias in Example 3,
Fig. 18 is a graph showing relationships between the film growth rate and the substrate bias in Example 3,
Fig. 19 is a chart of an Auger electron spectroscopy in Run No. 3 of Example 5, and
Fig. 20 is a chart of an Auger electron spectroscopy in Run No. 6 of Example 5.

### DETAILED DESCRIPTION OF THE INVENTION

The DLC film is a carbonaceous film having the similar properties to those of diamond, while it is amorphous. Its structure seems to be a mixture of a component having a diamond bond (sp³ bond), a component having a graphite bond (sp² bond) and amorphous carbon.

The properties of the DLC film have a close relationship with a ratio of the components. When a content of the diamond bond component is larger, the properties of the DLC film is closer to those of diamond. In addition, the DLC film is characterized in that its coefficient of friction greatly depends on a speed and it is small when the tape is slid on the DLC film, while its coefficient of static friction or its coefficient of kinetic friction at a very low speed is large.

When the DLC film of the present invention having the Knoop hardness of at least 5000 kg/mm², and a density of not larger than 3 g/cm³ is formed on the peripheral surface of the capstan axle, a tape driving force is increased and the tape driving apparatus has at least 20 % better driving efficiency than the capstan axle having the conventional DLC film.

While an exact reason for the high driving force of the DLC film of the present invention has not been clarified, it has been found that a DLC film having a comparatively large amount of the diamond bonds has low denseness.

In the method for producing the DLC film, the plasma is generated from the raw material gas, accelerated and then deposited on the substrate, whereby a highly energized state which creates the diamond bond is generated in a very small area on the substrate. Therefore, the many diamond components may be distributed in the film and the film may be in a completely amorphous state. As the result, the film may have a small modulus of elasticity and then the tape driving force is increased. In addition, since the DLC film is excellent in wear resistance, the high driving force can be maintained stably for a long time.

Further, since the DLC film has an internal stress therein, an adhesion force between the DLC film and the substrate is important. When the silicon-containing carbon film is formed as an intermediate layer between the substrate such as the capstan axle and the DLC film, the adhesion of the DLC film to the substrate is increased.

The silicon-containing intermediate carbon film can be formed by substantially the same method as the DLC film forming method, for example, generating a plasma from a gas containing silicon and carbon atoms, accelerating the ions in the plasma and depositing them on the substrate. As the carbon source, any of conventionally used hydrocarbons or other organic compounds may be used. As the silicon source, also any of conventionally used silicon-containing compounds such as silane and silazane compounds may be used.

The silicon atom easily bonds with the carbon atom and is a suitable element as one of the elements of the intermediate layer.

Since the intermediate layer contains the carbon atoms also, a part of them form the diamond bonds to provide an intermediate film similar to the DLC film during the formation of the intermediate film. Since such method can increase the hardness of the intermediate layer, the intermediate layer which can stand the shear force generated by the pinch roller is formed while the adhesion of the film is improved. That is, when the hardness of the intermediate layer is at least 1000 kg/mm², the adhesion of the DLC film can be best improved.

Since the large pressing force is applied to the capstan axle by the pinch roller as explained above, when the hardness of the intermediate layer is less than 1000 kg/mm², the DLC film may be peeled off because of the fracture of the intermediate layer, though the DLC film is made hard. Then, the intermediate layer having the suitable hardness improves the adhesion of the whole films.

In addition, the silicon-containing carbon film and the DLC film can be successively formed in a same reaction chamber only by changing the raw materials. Therefore, the capstan axle having two carbonaceous films can be produced in a single process without deteriorating the productivity.

In the formation of the DLC film, an alkylbenzene having at least one alkyl group on the benzene ring is preferably used as the carbon source, while any other conventionally used hydrocarbon or organic compound may be used as the carbon source.

Examples of the alkylbenzene are toluene, xylene, trimethylbenzenes, ethylbenzene, triethylbenzene, and the like.

With the alkylbenzene, the DLC film having a small internal stress can be produced. Further, the hardness of the DLC film is increased.

Usually, the metal substrate has an oxidized layer on its surface. For example, a stainless steel substrate has usually an oxide layer with a thickness of 30 to 50 Å, which comprises Fe₂O₃, Fe₃O₄, Cr₂O₃, and so on. The oxidized layer deteriorates the adhesion of the DLC film to the substrate. The carbon atoms of the DLC film hardly form bonds with the oxygen atoms. If they form bonds, the carbon atoms form carbon monoxide or carbon dioxide and are vaporized.

Comparing enthalpies of formation of oxides such as Fe₂O₃, Fe₃O₄ and Cr₂O₃ and carbides such as Fe₃C, Cr₃C₂ and SiC, the former has the smaller enthalpy of formation than the latter as shown below. This means that the oxide is easily formed than the carbide, and the oxide on the substrate cannot be replaced by the carbide during the formation of the DLC film. Accordingly, when the oxide is present on the substrate, the adhesion of the DLC film to the substrate is not increased.

| Material | Enthalpy of formation (kJ/mol) |
|---|---|
| Fe₂O₃ | -824 |
| Fe₃O₄ | -1118 |
| Cr₂O₃ | -1140 |
| Fe₃C | +25 |
| Cr₃C₂ | -81 |
| SiC | -63 |

When the oxidized layer is removed by the irradiation of ionized inert gas such as argon, neon, krypton and the like, and the DLC film is formed on the substrate without exposing the substrate to an air, the adhesion of the DLC film to the substrate is much improved.

As seen from the above table of the enthalpy of formation, chromium and silicon are elements which have the low enthalpy of formation of a carbide and increase the adhesion of the DLC film to the substrate. These elements form their carbides more easily than iron.

The enthalpy of formation of Fe₃C is positive. This means that the bonds between iron and carbon atoms is broken unless the energy of +25 kJ/mol is applied always. Then, the chromium atoms in the stainless steel greatly contribute to the increase of the adhesion force between the DLC film and the stainless steel substrate as the result of the removal of the oxide layer.

When the stainless steel is thermally treated to form a chromium rich layer by the segregation of chromium on the surface, the adhesion of the DLC film is further improved. The same effect can be achieved by the doping of chromium atoms with an ion gun.

Now, the present invention will be explained in detail by making reference to the accompanying drawings.

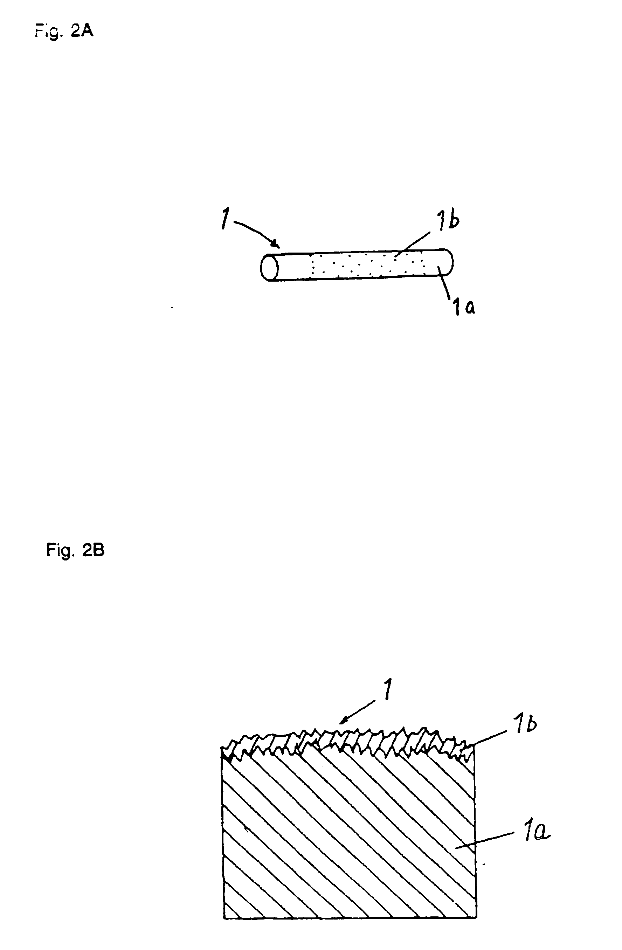

Fig. 2A shows a perspective view of an example of the capstan axle 1 of the present invention, and Fig. 2B shows an enlarged view of a partial cross section of the capstan axle 1, which comprises a capstan body 1a and a DLC film 1b having, for example, a thickness of 0.3 µm, a Knoop hardness of 5000 kg/mm², and a density of 2.5 g/cm³.

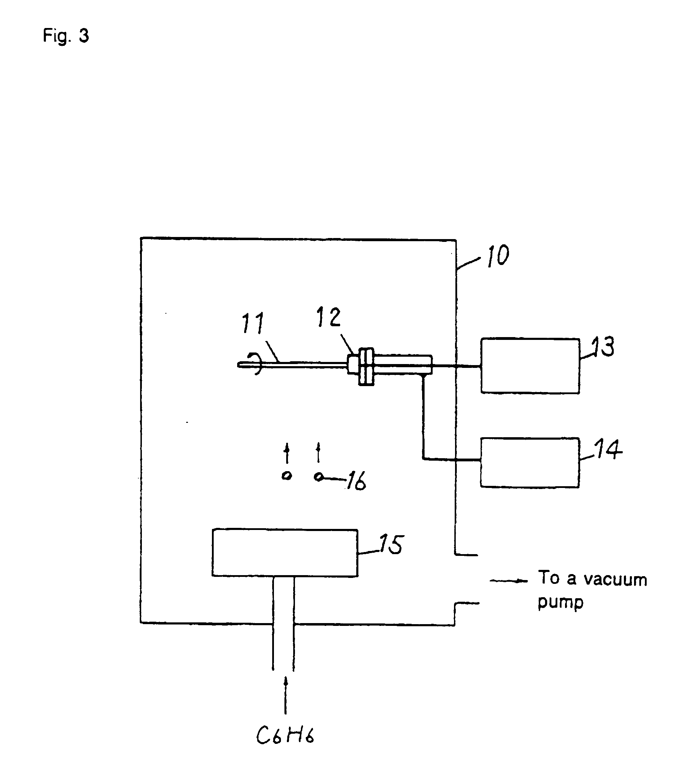

Fig. 3 shows an apparatus for forming the DLC film. In a vacuum chamber 10, an ion source 15 is provided and a capstan-holding member 12 is positioned above the ion source 15. The holding member 12 is attached directly to a motor 13 to rotate the holding member 12. The holding member is connected to a direct current source 14 to apply a direct current bias to a substrate 11 which is held by the holding member 12.

The procedure for the formation of the DLC film will be explained.

An interior of the vacuum chamber 10 is evacuated by a vacuum pump (not shown) to a pressure of 10⁻⁴ to 10⁻⁶ torr. While a raw material such as benzene is introduced in the ion source 15, an electricity is applied to a heating filament (not shown) in the source 15 to generate a plasma by thermoelectrons from the filament.

The capstan axle 11 as the substrate is attached to the holding member 12 and a minus bias is applied to the capstan axle 11 to generate an electric field which accelerates the ions 16. Then, the ions 16 collide to the capstan axle 11 to form the DLC film.

### Example 1

In the first example, benzene was used as the raw material gas, the DLC film was formed on a silicon wafer using the apparatus of Fig. 3, and properties of the DLC were examined.

The pressure in the vacuum chamber 10 was adjusted in the range between 5 x 10⁻⁴ and 1.5 x 10⁻³ torr, and a DLC film quality was controlled by changing the applied bias to the substrate.

The typical conditions for the formation of DLC film were as follows:
Pressure: 1.2 x 10⁻³ torr
Flow rate of the raw material gas: 6.0 SCCM
Substrate potential: -0.3 to -3.0 V
Electric current in substrate: 10 mA
Discharge current: 1.5 A

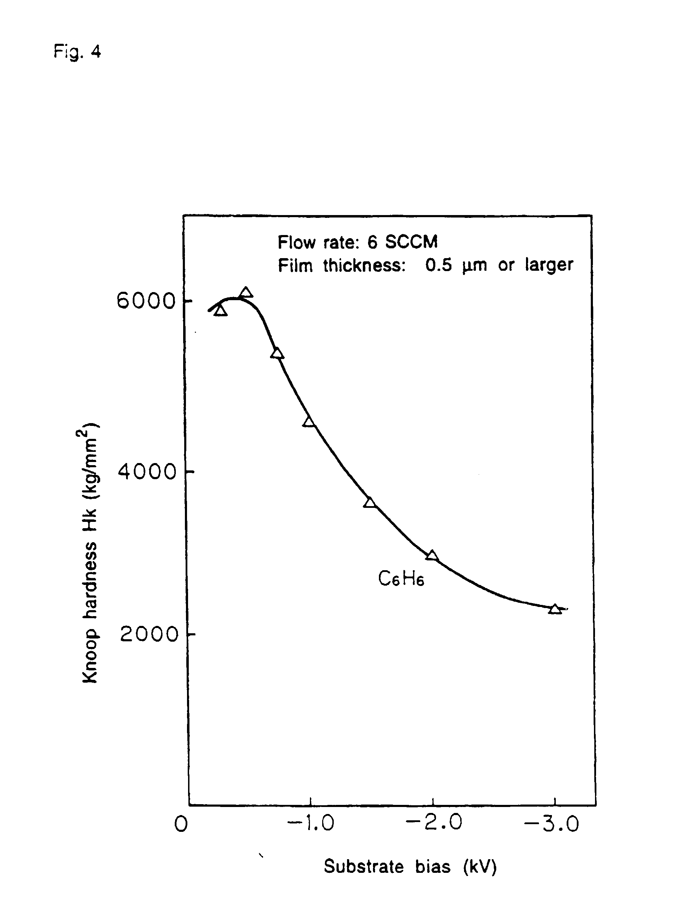

Fig. 4 shows a relationship between the Knoop hardness of the DLC film and the substrate bias.

The hardness of the DLC film was maximum around the applied bias of -0.75 V.

With two DLC films produced by the above method having
(a) Knoop hardness of 5000 kg/mm², and
(b) Knoop hardness of 3000 kg/mm²,
film properties were examined.

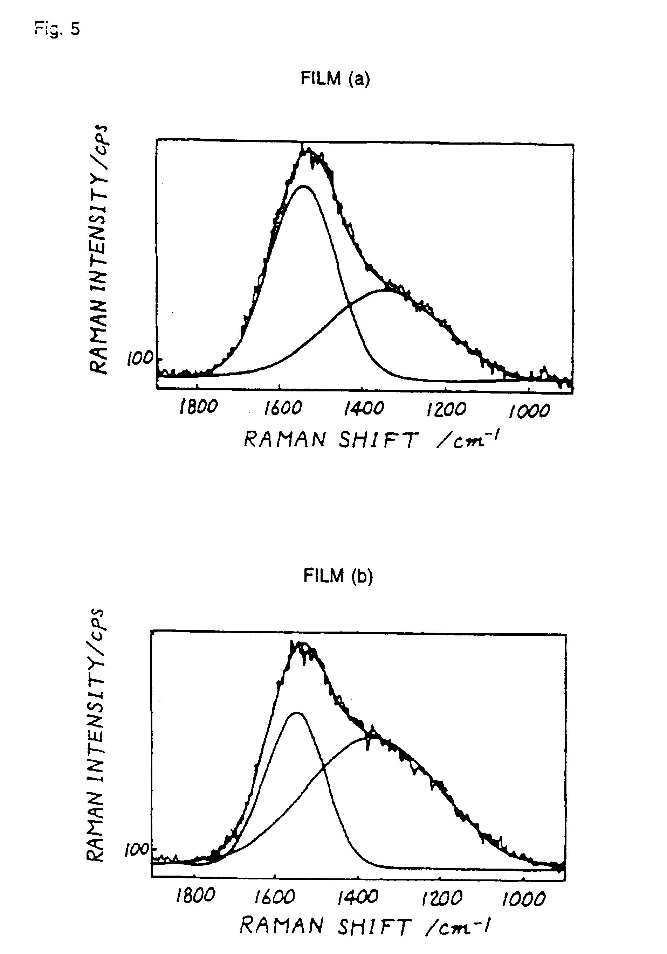

Fig. 5 shows the Raman spectra of the films (a) and (b), respectively.

Both shows the typical spectra of the DLC films, and two broad peaks around 1360 cm⁻¹ and 1560 cm⁻¹ were observed.

From a ratio of areas of these two peaks, it is understood that the film (a) contained more sp³ component, namely the diamond bond component than the film (b).

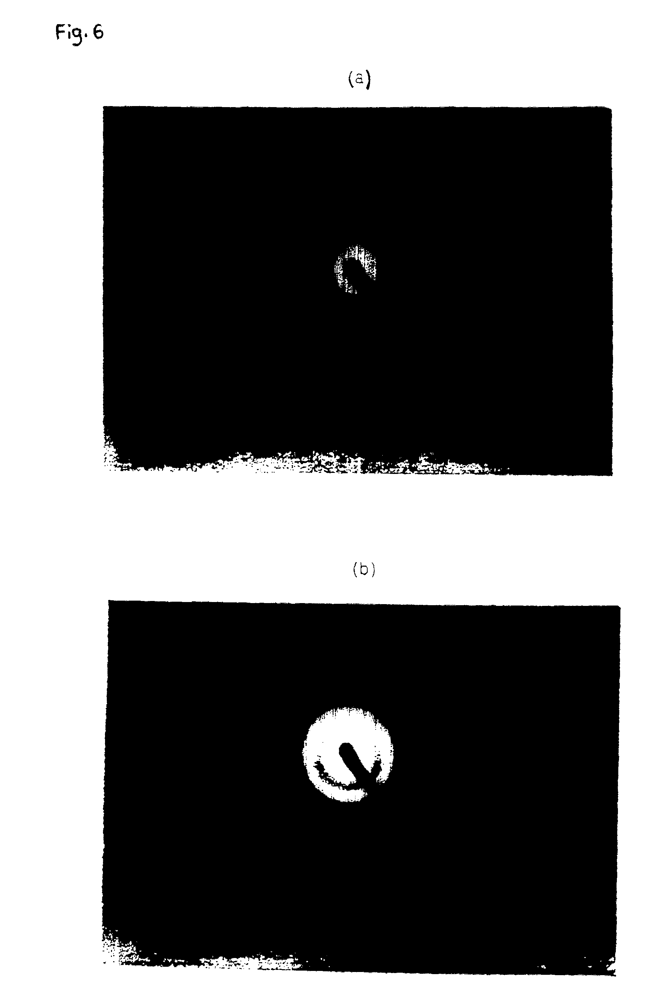

Fig. 6 shows electron beam diffraction patterns of the films (a) and (b), respectively. The diffraction pattern of the film (a) was a complete halo-pattern, while a dull diffraction ring was observed in the diffraction pattern of the film (b).

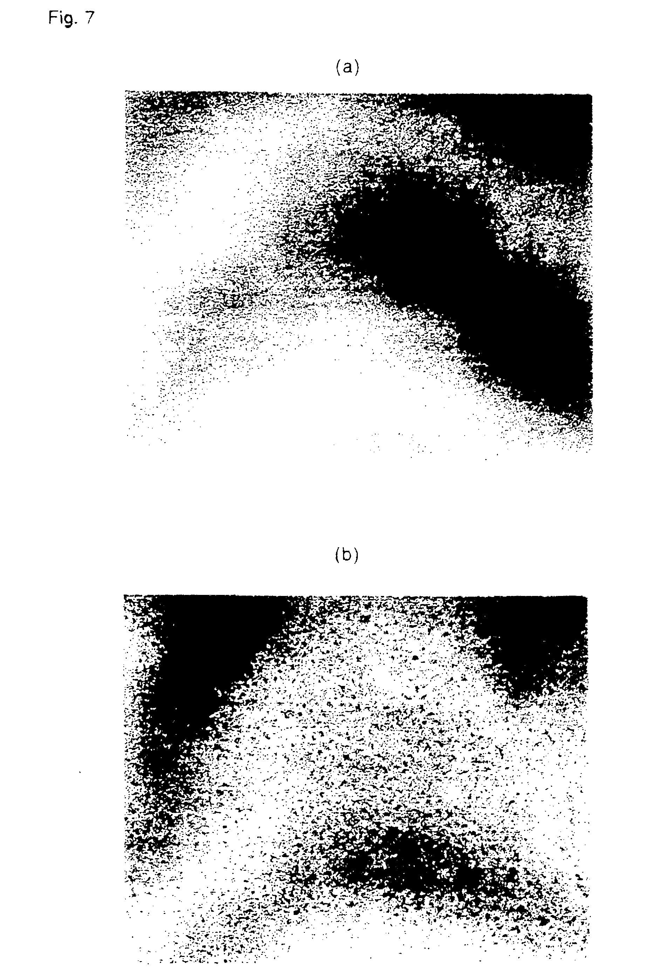

Fig. 7 are the transmission electron micrographs of the films (a) and (b). In the film (a), no crystalline particle was observed, while the film (b) had a slight regularity.

From the above results, it is seen that the film (a) might be in the completely amorphous state, while the film (b) might have a slight crystalline structure.

In the short range order of the film (b), a spacing was calculated to be from about 0.35 to 0.4 nm

Since the film (b) had slight electrical conductivity in comparison to the film (a), the structure of the film (b) may be close to graphite.

Table 1 shows densities and hydrogen contents of the films (a) and (b) which were measured by the Rutherford back scattering (RBS) method and the ERDA.

**Table 1**

| Kind of film | Density (g/cm³) | Hydrogen content (%) |
|---|---|---|
| Film (a) | 2.49 | 25 |
| Film (b) | 3.10 | 26 |

That the film (a) had the smaller density than the film (b) indicates that the film (a) had less crystallinity and denseness, and well coincides with the observations by the electron beam diffraction and the transmission electron microscope. The hydrogen contents in the films (a) and (b) were substantially the same.

From the above results, it is understood that the film having the Knoop hardness of 5000 kg/mm² contained many sp3 bonds, namely the diamond bonds, and those bond states were dispersed randomly in the film. Further, the denseness of this film was less than the film having the Knoop hardness of 3000 kg/mm².

Next, each of the above DLC films was formed on a peripheral surface of the capstan axle as shown in Fig. 2A. The capstan axle had a diameter of 2 mm and a length of 32 mm.

Using the capstan axle, the tape driving force shown in Fig. 1 was set up, and a tape driving force was measured as follows:

A pressing force of the pinch roller 22 to the capstan axle 21 was kept constant at 600 g, and the magnetic tape 23 was traveled with applying a tape tension T to the tape 23 in a direction reverse to the driving direction. With changing the tape tension T, the tape was driven. The tape tension T, by which a 0.5 % slip was generated between the peripheral speed of the capstan axle 21 and the tape traveling speed, was defined as the tape driving force.

The pinch roller 22 had a diameter of 5 mm and a length of 13 mm, and a magnetic tape had a width of 12.7 mm.

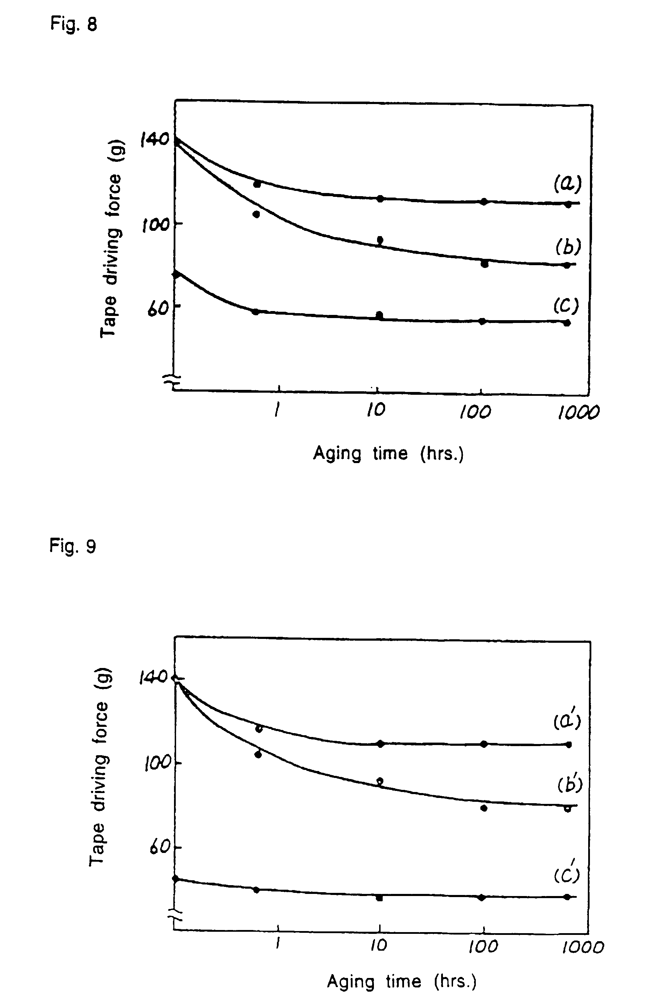

Fig. 8 shows aging characteristics of the driving force of each of the following capstan axles:
(a) Capstan axle having the DLC film of the present invention with the Knoop hardness of 5000 kg/mm², the density of 2.49 g/cm³ and the hydrogen content of 25 %;
(b) Capstan axle having the DLC film with the Knoop hardness of 3000 kg/mm², the density of 3.10 g/cm³ and the hydrogen content of 26 %;
(c) Capstan axle having no DLC film.

The capstan axle had the surface roughness Rₘₐₓ of 0.2 µm, and the thickness of the DLC film was 0.3 µm. A coated width of the DLC film was 17 mm.

The untreated capstan axle (c) had the very low driving force. While the capstan axle (b) had the larger driving force than the capstan axle (c), the driving force changed greatly with the increase of the aging time.

In comparison with the capstan axle (b), the capstan axle (a) of the present invention had less change of the driving force and its saturation value was larger.

From the above result, the capstan axle (a) with the DLC film (a) had the best driving force among three capstan axles.

To decrease the influence of the surface roughness of the capstan axle on the driving force, the surface roughness of the capstan axle was decreased to 0.02 to 0.04 µm, and the same aging test as above was carried out with the untreated capstan axle (c'), the capstan axle having the DLC film having the Knoop hardness of 5000 kg/mm² (a'), and the capstan axle having the DLC film having the Knoop hardness of 3000 kg/mm² (b')

The results are shown in Fig. 9.

Though the capstan axles (a') and (b') had the same surface roughness of the base capstan axle, the same tendency as that in Fig. 8 was observed.

This result indicates that the difference of the driving force does not relates significantly to the surface roughness but relates to the physical properties of the DLC films.

From the above analysis of the DLC films, it is understood that the denseness of the DLC film may have the influence on the aging of the driving force of the capstan axle. That is, the film (a) which is amorphous and has little denseness may be elastically deformed by an external force and have a small modulus of elasticity. As the result, a coefficient of friction against the magnetic tape becomes large so that the driving force is increased.

A relationship between a driving force and a ratio of the width B to the width A in Fig. 1B was examined.

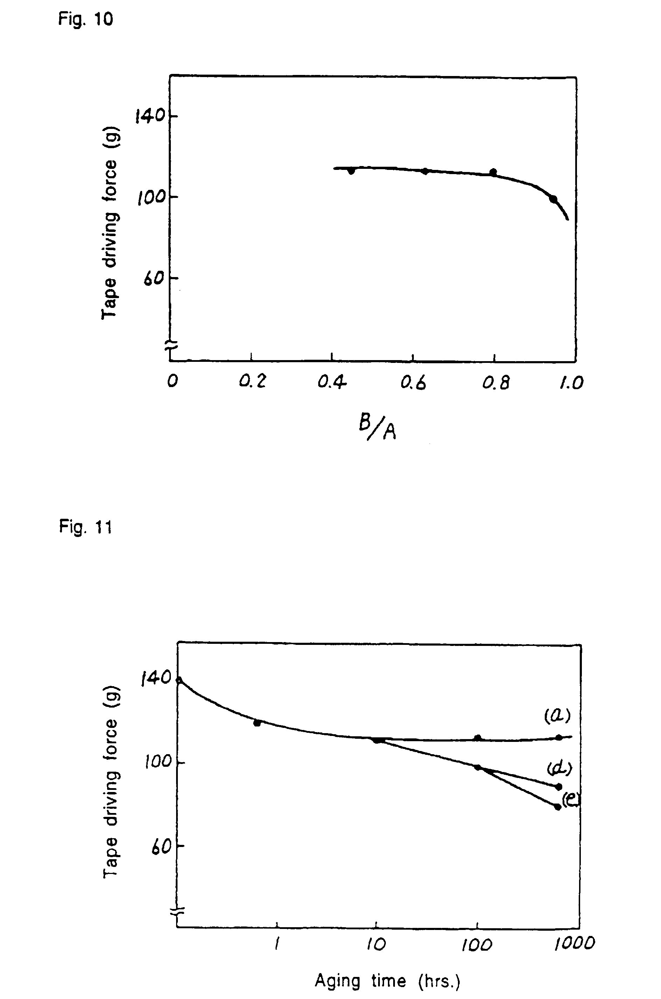

Fig. 10 shows this relationship.

As described above, the DLC film has the good tape driving property with the magnetic tape. When the width B of the capstan axle which contacts to the pinch roller is too large in comparison to the width A of the capstan axle which contacts directly to the magnetic tape, the tape driving property of the DLC film tends to be deteriorated. That is, when the ratio B/A is larger than 0.8, the tape driving force decreases as seen from Fig. 10.

An influence of the thickness of the DLC film on the driving force was examined by changing the DLC film thickness to (d) 0.1 µm and (e) 0.5 µm.

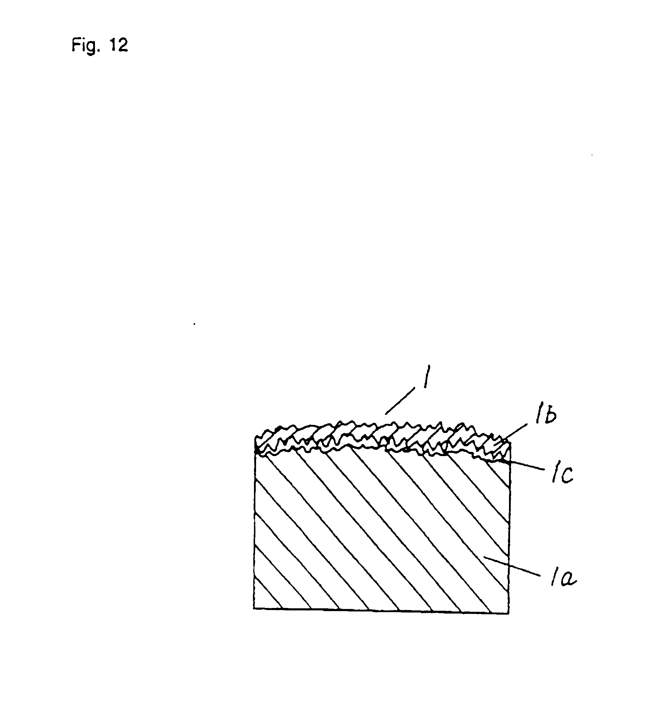

The results are shown in Fig. 11.

When the thickness of the DLC film is small (in the case of (d)), the protruded parts of the capstan axle were worn so that the material of the capstan body was exposed and the driving force was decreased. Then, it is preferred that the DLC film is coated in a sufficient thickness for preventing the exposure of the base material when the protruded parts are worn.

When the thickness of the DLC film is large (in the case of (e)), the adhesion of the film to the capstan surface was reduced so that the film was peeled off. As the result, the driving force was decreased.

Consequently, when the surface roughness of the capstan axle is 0.2 µm, the thickness of the DLC film is preferably from 0.2 to 0.4 µm.

### Comparative Example

For comparison, a DLC film was formed on a surface of the same silicon wafer as that used in Example 1 by a high frequency wave plasma CVD method using benzene as a raw material. The film formation conditions were as follows:
Benzene: 5 SCCM
Hydrogen: 5 SCCM
High frequency power: 150 W
Pressure: 1 x 10⁻² torr.

The DLC film formed on the silicon wafer had the Knoop hardness of 1500 kg/mm², which was much lower than the Knoop hardness of the DLC film formed by the ion beam method.

On the same capstan axle as used in above Example 1, a DLC film was formed by the same high frequency wave plasma CVD method as above. The film was peeled off from the capstan axle surface and its properties could not be evaluated.

### Example 2

Fig. 12 shows an enlarged cross section of a second example of the capstan axle according to the present invention.

The capstan body 1a was made of non-magnetic stainless steel. On the peripheral surface of the capstan body 1a, a film 1c containing silicon and carbon and having the Knoop hardness of 3000 kg/mm² and a thickness of 0.05 µm was formed as an intermediate layer, and on the film 1c, a DLC film 1b having the Knoop hardness of 5000 kg/mm², the density of 2.5 g/cm³, the hydrogen content of 25 % and a thickness of 0.3 µm was formed.

The film containing silicon and carbon was formed using the apparatus of Fig. 3 by introducing tetramethylsilane as a raw material gas.

The hardness of this film 1c was changed by changing the substrate bias as in the case of the DLC film.

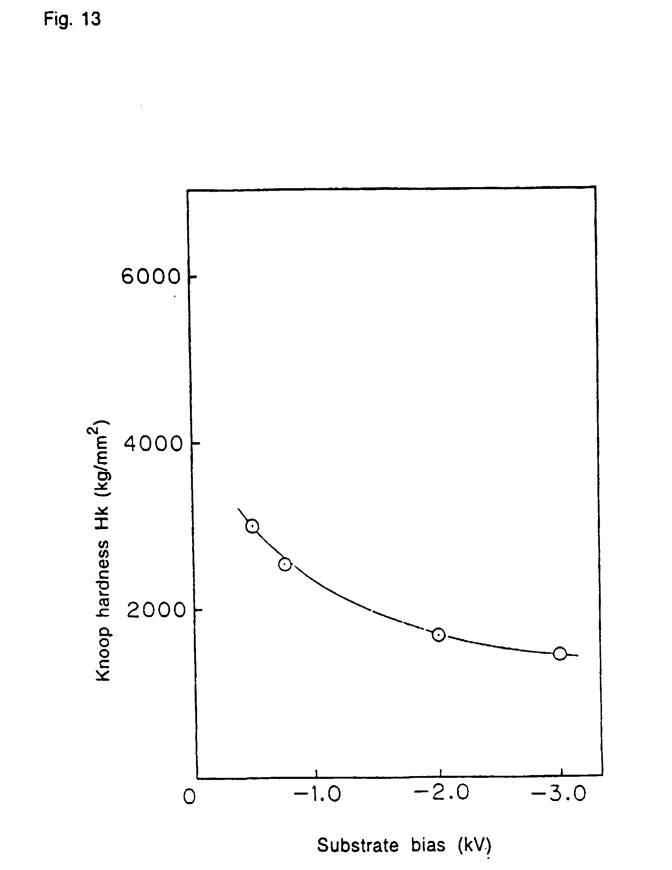

A relationship between the bias applied to the substrate and the Knoop hardness is shown in Fig. 13. In this case, the film having the Knoop hardness of 3000 kg/mm² was obtained at a relatively low bias.

The obtained silicon-containing carbon film was analyzed by the Raman spectroscopy to find that there were Raman shifts having peaks around 1580 cm⁻¹ and 1360 cm⁻¹, respectively, when the film had the Knoop hardness of 3000 kg/mm². This indicates that the silicon-containing carbon film has the very close film structure to that of the DLC film. But, the silicon-containing carbon film having the Knoop hardness of 500 kg/mm² may have a film structure similar to an organic polymer film from the Raman shifts.

On the film 1c, the DLC film 1b was formed in the same manner as in Example 1.

Next, two additional capstan axles (f) and (g) were produced by changing the property of the film 1c while maintaining the property of the DLC film unchanged. The intermediate film 1c had the Knoop hardness of
(f) 500 kg/mm²
(g) 2000 kg/mm².

The film property of the DLC film was the same as that of the film (a) in Example 1. The thicknesses of the intermediate film 1c and the DLC film 1b were 25 nm and 0.3 µm, respectively.

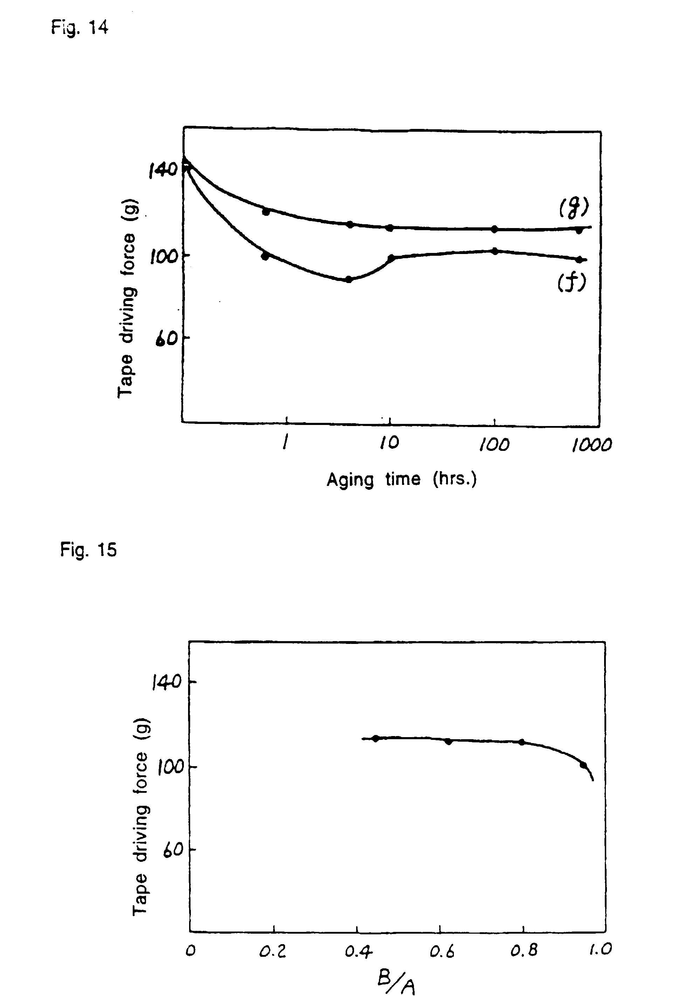

The results of the aging test are shown in Fig. 14.

When the intermediate film was soft as in the case of the film (f), the unstable driving force was observed in the initial stage of the aging test. This is because, due to too softness of the intermediate film, the intermediate film could not stand the shear force generated by the pinch roller and were peeled off from the capstan body. In the case of the film (g), since the intermediate film was relatively hard, the film was not peeled off, and the good property was obtained.

For comparison, a DLC film was formed on the capstan axle surface by the same plasma CVD method as in above Comparative Example, and its properties were evaluated. As the intermediate film, the film (g) was used. Because of the presence of the intermediate film, the DLC film could be formed on the capstan axle without peeling. However, the driving force was as low as about 80 g, which was in the same level as the conventional capstan axle. Further, the durability was poor and the driving force decreased only after 20 hours from the start of the aging test.

In the same manner as above except that an amorphous silicon film was formed as the intermediate layer in place of the silicon-containing film, the capstan axle having the DLC film was produced. The amorphous silicon film was formed by the vapor deposition method. The driving force was substantially the same as that obtained when the film (f) was used. The amorphous silicon film had the Knoop hardness of about 800 kg/mm². Then, the DLC film may be peeled off from the intermediated film by the strong pressing force of the pinch roller.

Next, as in Example 1, the relationship between the driving force and the B/A ratio was examined, and the results are shown in Fig. 15. The relationship in this Example was substantially the same as that in Example 1.

That is, when the B/A ratio was larger than 0.8, the width B of the part of the capstan axle contacting the pinch roller is large in comparison with the width A of the part of the pinch contacting directly the magnetic tape, so that the effect of the DLC was reduced and then the tape driving force was decreased.

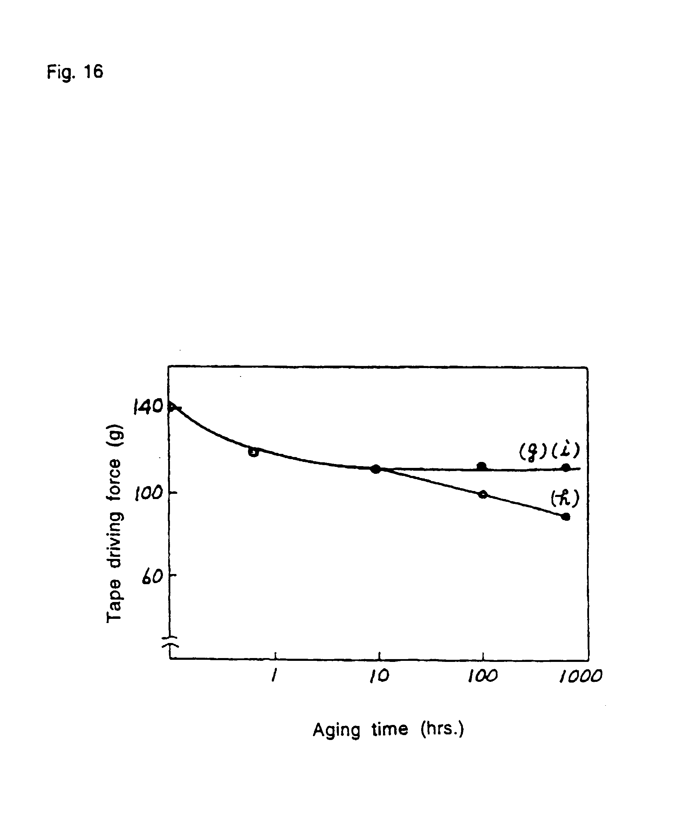

As in the case of the film (g), the DLC film having the thickness of 0.1 µm (capstan (h)) or 0.5 µm (capstan (i)) was formed on the intermediate film. The results of the aging test are shown in Fig. 16.

As in the case of Fig. 11, when the thickness of the DLC film was thin and the surface roughness was large, the material of the capstan body was exposed due to wearing, and in turn the driving force was decreased.

When the thickness of the DLC film was thick, different from the case of Fig. 11, the adhesion of the DLC film was increased due to the presence of the intermediate film. Accordingly, the capstan (i) had substantially the same properties as the capstan (g).

It is seen that, when the thickness of the DLC film is larger than the maximum height of the surface roughness of the capstan body, the good property is obtained.

From the above results, when the silicon-containing carbon film having the Knoop hardness of 3000 kg/mm² was present as the intermediate layer, the adhesion of the DLC film is improved and the high tape driving force is stably obtained for a long time.

### Example 3

In the same manner as in Example 1 except that toluene or methane was used in place of benzene, the DLC film was formed on the peripheral surface of the capstan body.

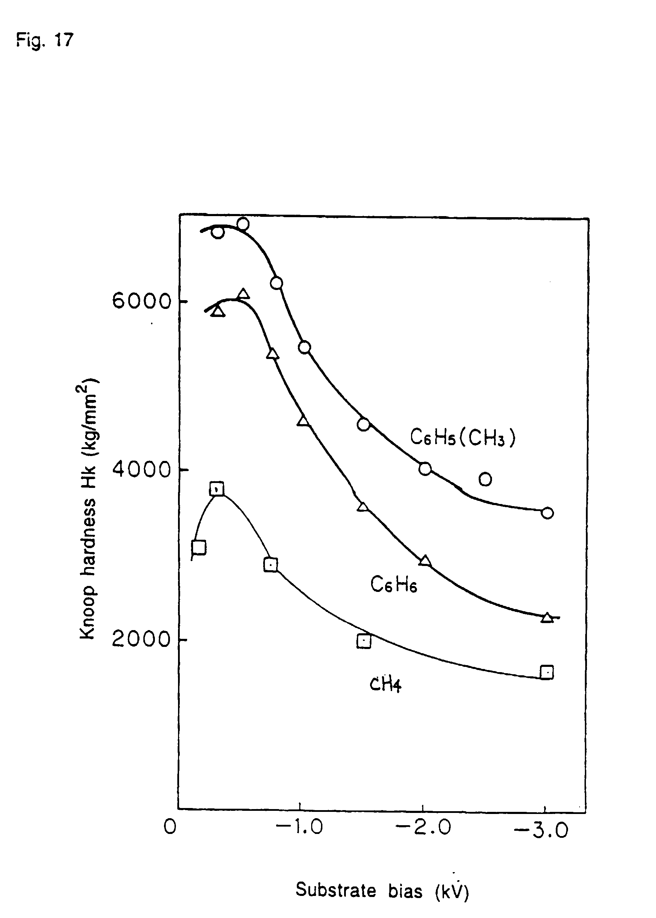

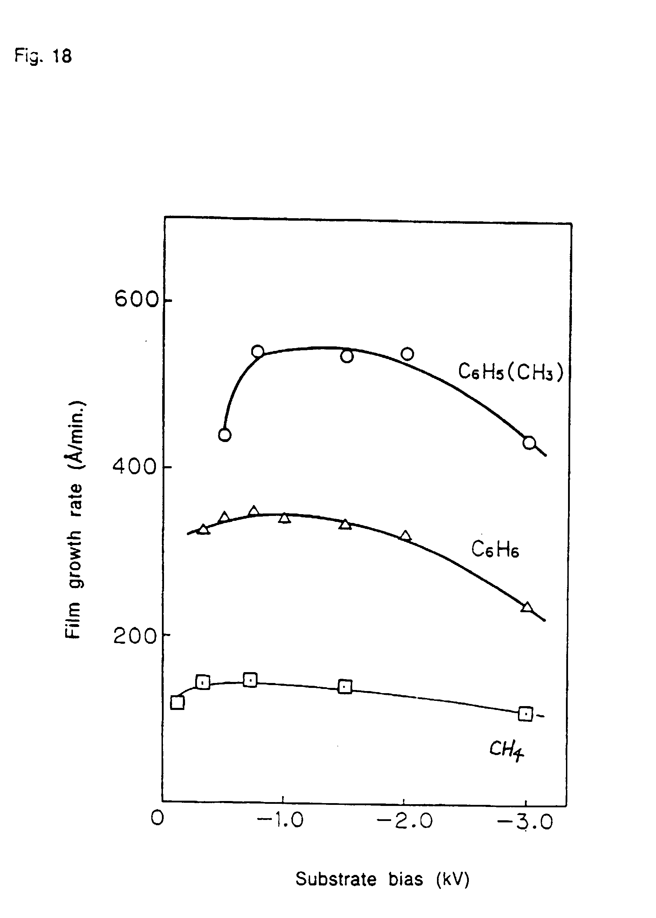

Fig. 17 shows the relationships between the Knoop hardness and the substrate bias, and Fig. 18 shows the relationship between the film growth rate and the substrate bias.

As seen from Fig. 17, the DLC film formed from toluene was hardest, and that formed from benzene was softer than that formed from toluene. The DLC film formed from methane was softest.

As seen from Fig. 18, the film growth rate was in the order of toluene, benzene and methane.

### Example 4

On a rectangular silicon wafer, a DLC film was formed. Then, an internal stress of the film was calculated from a degree of deformation of the film after the film formation.

Table 2 shows the internal stress of the film obtained when the hardest DLC film was formed from each of the raw materials, toluene, benzene and methane.

The adhesion of the film was evaluated as follows:

On a SUS 420 J2 post which had been cleaned by ultrasonic wave, a DLC film having a thickness of 0.4 µm was formed and subjected to the thermal shock test (keeping at -40°C and +80°C each for one hour, 10 cycles).

**Table 2**

| Raw material | Substrate bias (kV) | Residual stress (kg/mm²) | Vickers hardness (kg/mm²) | Adhesion |
|---|---|---|---|---|
| Toluene | -0.75 | 180 | 7000 | No peeling |
| Benzene | -0.75 | 540 | 5000-6000 | Peeled off |
| Methane | -0.30 | 260 | 3800 | Peeled off |

While the DLC film formed from toluene was hardest, the internal stress was smallest.

As seen from the above results, when toluene is used as the raw material, the DLC film having good hardness and small internal stress can be formed with good adhesion and productivity, and has the better property than the DLC film formed from benzene.

When other alkyl benzene such as xylene is used, a DLC film having substantially the same properties as above can be obtained.

### Example 5

In the apparatus of Fig. 3, argon was introduced and an argon plasma was generated. With applying the negative bias to the capstan axle, argon ions were irradiated on the capstan surface. Thereafter, a DLC film was formed using toluene as in Example 4.

The relationship between the irradiation condition of argon and the adhesion of the DLC film to the capstan axle is shown in Table 3.

**Table 3**

| Irradiation condition of argon ions | | | | | |
|---|---|---|---|---|---|
| Run No. | Substrate voltage (kV) | Substrate current (mA) | Time (min.) | Thermal shock test | Thermal shock test + Tensile test |
| 1 | -1.0 | 10 | 5 | Spontaneous peeling after long time storing | - - - |
| 2 | -1.5 | 10 | 5 | ↑ | - - - |
| 3 | -3.0 | 10 | 5 | Δ^{*1)} | Peeled off |
| 4 | -3.0 | 20 | 5 | No peeling | Peeled off |
| 5 | -3.0 | 20 | 7.5 | No peeling | Partly peeled off |
| 6 | -3.0 | 20 | 15 | No peeling | No peeling |

| | | | | | |
|---|---|---|---|---|---|
| Note: *1) Though not being peeled off, small areas of the film were floated. | | | | | |

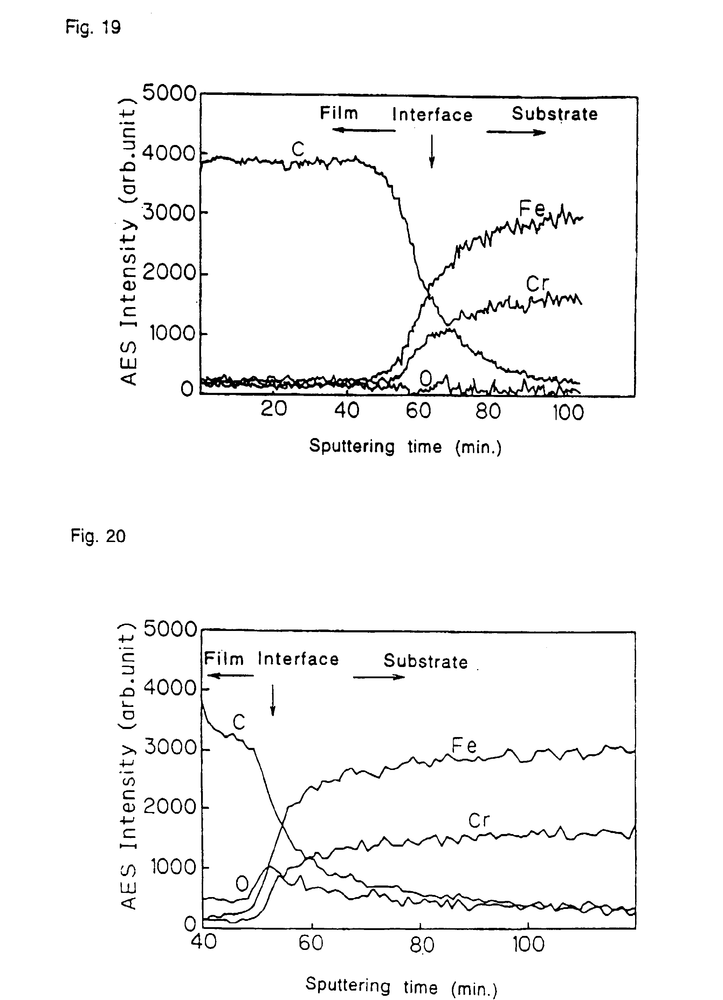

With the films formed in Run Nos. 3 and 6, elementary analysis at the interface between the capstan axle and the DLC film was carried out by the Auger electron spectroscopy. The results of Run Nos. 3 and 6 are shown in Figs. 19 and 20, respectively.

While the oxygen atom were present at the interface of the film obtained in Run No. 3, while no oxygen was detected at the interface of the film obtained in Run No. 6. That is, under the conditions of Run No. 3, the oxidized layer was not sufficiently removed from the surface of the capstan axle. Thereby, the adhesion of the DLC film to the capstan axle may be deteriorated. Accordingly, when the oxidized layer is thoroughly removed from the capstan surface, the adhesion of the DLC film can be improved.

It is difficult to confirm whether or not the oxidized layer is thoroughly removed during the formation of the DLC film. Then, the removal of the oxidized layer is indirectly confirmed as follows:

During the irradiation of argon ions, as the oxidized layer is removed with the progress of cleaning, a discharge current (a current passing through a mesh electrode) or a substrate current gradually decreases while other conditions such as a filament passing current, a substrate bias and a mesh electrode voltage are maintained the same. That is, when the oxidized layer is present, secondary electrons are easily emitted when the ions collide with the substrate. As the result, a plasma density is increased so that the discharge current or the substrate current is increased. As the oxidized layer is removed, the emission of secondary electrons is decreased and then the discharge current or the substrate current is decreased.

In this Example, completion of the removal of the oxidized layer is judged from the stopping of the decrease of the discharge current or the substrate current. This judging method well coincides with the results of the Auger electron spectroscopy. That is, when the irradiation of argon ions was stopped while the discharge current or the substrate current was still decreasing, the oxygen atoms were detected from the interface. When the DLC film was formed after the decrease of the discharge current or the substrate current stopped, no oxygen atom was detected from the interface.

Accordingly, by the removal of the oxidized layer from the surface of the capstan, the adhesion of the DLC film to the capstan is greatly improved.

### Example 6

Another reason for the improvement of the adhesion of the DLC film by the removal of the oxidized layer may be the segregation of chromium atoms on the surface of the capstan.

In this Example, the same stainless steel capstan body as used in the previous Examples was thermally treated at 400°C for 2 hours to segregate chromium on the surface. Thereafter, the argon ions were irradiated to remove the oxidized layer and the DLC film was formed in the same manners as in Example 5.

According to the Auger electron spectroscopy, this thermal treatment increased the ratio of chromium to ion (Cr/Fe ratio) on the capstan surface to 0.33 from the Cr/Fe ratio of 0.15-0.18 in the case of the capstan axle which was not thermally treated.

As the result, by the thermal treatment and the removal of the oxidized layer, the adhesion of the DLC film to the capstan body is significantly improved.

Table 4 shows the results of the aging test of the capstan axle used as a part of the tape driving apparatus as in Example 1.

The DLC film was not peeled off by the combination of the thermal shock test and the tensile test, and the good driving property was obtained in the aging test. There was no material difference of the driving property between the film formed from toluene and that formed from benzene.

**Table 4**

| Run No. | Raw material | Thermal treatment | Properties of DLC film | | Aging test^{*1)} (O: Driving force of 100 g or lager) |
|---|---|---|---|---|---|
| | | | Knoop hardness (kg/mm²) | Thickness (µm) | |
| 1 | Toluene | No | 7000 | 0.24 | Film peeled off |
| 2 | Toluene | Yes | 7000 | 0.24 | O |
| 3 | Toluene | Yes | 7000 | 0.12 | O |
| 4 | Toluene | Yes | 7000 | 0.08 | O |
| 5 | Benzene | Yes | 5000 | 0.20 | O (sliding flaws) |
| 6 | Benzene | Yes | 5000 | 0.13 | Worn, underlayer exposed |
| 7 | Benzene | Yes | 3000 | 0.20 | O (sliding flaws) |

| | | | | | |
|---|---|---|---|---|---|
| Note: *1) The film condition was observed after traveling the magnetic tape under the pinch roller-pressing pressure of 600 g for 500 hours. | | | | | |

### Example 7

As explained above, the silicon or chromium elements contribute to the increase of the adhesion of the DLC film to the capstan axle. When the substrate material does not contain these elements, these elements can be doped in the material to achieve the same effect.

As a substrate, a carbon tool steel SK 3 was used and doped with the chromium elements and annealed. After removing the oxidized layer, the DLC film was formed on the substrate.

The doping was carried out at an ion energy of 10 KeV, and the doped amount of chromium element was 5 x 10¹⁴ atoms/cm².

After doping, the substrate was annealed at 550°C and the oxidized layer was removed by the irradiation of argon ions.

The DLC film was formed by the following conditions:
Raw material: Toluene
Substrate bias: -1 kV
Substrate current: 10 mA
Discharge current: 1.5 A
Film thickness: 0.2 µm.

The adhesion of the DLC film was evaluated by the thermal shock test and the tensile test. From the SK 3 substrate which was doped with the chromium elements, the DLC film was not peeled off, and the adhesion of the DLC film was in the same level as in the case of the stainless steel substrate.

From the SK 3 substrate which was not doped with chromium elements, the DLC film was peeled off when the substrate was recovered from the deposition apparatus.

The DLC film can be formed with good adhesion on a substrate containing no chromium element, when the chromium element is doped in a surface layer of the substrate.

The effect of the chromium doping can be attained with any metal material containing no chromium element.

Instead of the chromium element, doping of the silicon or carbon element which has a similar enthalpy of formation to that of chromium element can achieve the same effects as the chromium doping.

By the present invention, the DLC film having the quality as good as that formed from benzene can be formed on the capstan body. The capstan axle having the DLC film according to the present invention can provide the tape driving apparatus having the very high reliability and good driving performances.

## Claims

1. A tape driving apparatus comprising a capstan axle (1; 21) and a pinch roller (22) which presses a magnetic tape (23) to the capstan axle (1; 21), wherein said capstan axle (1) comprises, as an outermost layer, a diamond-like carbon film (1b) having a Knoop hardness of at least 5000 kg/mm²,
characterized in that said diamond-like carbon film (1b) of said capstan axle (1) has a density of not larger than 3 g/cm³, and a ratio of the width of a part of said capstan axle (1; 21) contacting said pinch roller (22) to the width of a part of said capstan axle (1; 21) contacting directly said magnetic tape (23) is not larger than 0.8.

2. The tape driving apparatus according to claim 1, wherein said capstan axle (1) further comprises a thin film (1c) comprising silicon and carbon and having a Knoop hardness of at least 1000 kg/mm² between the surface of a body (1a) of said capstan axle (1) and said diamond-like film (1b).

3. The tape driving apparatus according to claim 1 or 2, wherein the thickness of said diamond-like carbon film (1b) is at least 0.2 µm.

4. The tape driving apparatus according to claim 1, wherein said capstan axle (1) further comprises a chromium-rich layer (1c) between the surface of a body (1a) of said capstan axle (1) and said diamond-like film (1b).

5. The tape driving apparatus according to claim 4, wherein said chromium-rich layer (1c) is formed by doping chromium elements in the surface of said body (1a).

6. The tape driving apparatus according to claim 4, wherein said body (1a) comprises chromium elements, and said chromium-rich layer (1c) is formed by segregating chromium elements on the surface of said body (1a).

## Patentansprüche

1. Bandantriebsvorrichtung, aufweisend eine Bandantriebsrolle (1; 21) und eine Andruckrolle (22), die ein Magnetband (23) an die Bandantriebsrolle (1; 21) anpreßt, wobei die Bandantriebsrolle (1) als äußerste Schicht eine diamandartige Kohlenstoffschicht (1b) aufweist, die eine Knoop-Härte von mindestens 5.000 kg/mm² hat,
**dadurch gekennzeichnet, daß**
die diamandartige Kohlenstoffschicht (1b) der Bandantriebsrolle (1) eine Dichte von nicht größer als 3 g/cm³ hat und das Verhältnis der Breite des Anteils der mit der Andruckrolle (22) in Kontakt stehenden Bandantriebsrolle (1; 21) zur Breite des Anteils der mit dem Magnetband (23) direkt in Kontakt stehenden Bandantriebsrolle (1; 21) nicht größer als 0,8 ist.

2. Bandantriebsvorrichtung nach Anspruch 1, bei der die Bandantriebsrolle (1) außerdem eine Dünnschicht (1c) aufweist, die Silicium und Kohlenstoff enthält und zwischen der Oberfläche eines Körpers (1a) der Bandantriebsrolle (1) und der diamantartigen Schicht (1b) eine Knoop-Härte von mindestens 1.000 kg/mm² hat.

3. Bandantriebsvorrichtung nach Anspruch 1 oder 2, bei der die Dicke der diamantartigen Kohlenstoffschicht (1b) mindestens 0,2 µm ist.

4. Bandantriebsvorrichtung nach Anspruch 1, bei der die Bandantriebsrolle (1) zwischen der Oberfläche eines Körpers (1a) der Bandantriebsrolle (1) und der diamantartigen Schicht (1b) eine chromreiche Schicht (1c) aufweist.

5. Bandantriebsvorrichtung nach Anspruch 4, bei der die chromreiche Schicht (1c) durch Dotieren von Chromelementen in die Oberfläche des Körpers (1a) gebildet wurde.

6. Bandantriebsvorrichtung nach Anspruch 4, bei der der Körper (1a) Chromelemente enthält und die chromreiche Schicht (1c) durch Absonderung von Chromelementen auf der Oberfläche des Körpers (1a) gebildet wurde.

## Revendications

1. Appareil d'entraînement de bande comportant un axe de cabestan (1; 21) et un rouleau de pincement (22) qui presse une bande magnétique (23) sur l'axe du cabestan (1; 21), dans lequel ledit axe de cabestan (1) comporte, comme couche la plus à l'extérieure, un film de carbone de type diamant (1b) ayant une dureté de Knoop d'au moins 5000 kg/mm²,
caractérisé en ce que ledit film de carbone de type diamant (1b) dudit axe de cabestan (1) a une densité pas plus grande que 2 g/cm³, et un rapport de la largeur d'une partie dudit axe de cabestan (1; 21) en contact avec ledit rouleau de pincement (22) sur la largeur d'une partie dudit axe de cabestan (1; 21) en contact direct avec ladite bande magnétique (23), pas plus grand que 0,8.

2. Appareil d'entraînement de bande selon la revendication 1, dans lequel ledit axe de cabestan (1) comporte ne outre une couche mince (1c) comportant du carbone et du silicium et ayant une dureté de Knoop d'au moins 1000 kg/mm² entre la surface d'un corps (1a) dudit axe de cabestan (1) et ledit film de type diamant (1b).

3. Appareil d'entraînement de bande selon la revendication 1 ou 2, dans lequel l'épaisseur dudit film de carbone de type diamant (1b) est d'au moins 0,2 µm.

4. Appareil d'entraînement de bande selon la revendication 1, dans lequel ledit axe de cabestan (1) comporte en outre une couche riche en chrome (1c) entre la surface d'un corps (1a) dudit axe de cabestan (1) et ledit film de type diamant (1b).

5. Appareil d'entraînement de bande selon la revendication 4, dans lequel ladite couche riche en chrome (1c) est formée en dopant des éléments de chrome dans la surface dudit corps (1a).

6. Appareil d'entraînement de bande selon la revendication 4, dans lequel ledit corps (1a) comporte des éléments de chrome, et ladite couche riche en chrome (1c) est formée en isolant des éléments de chrome sur la surface dudit corps (1a).
